# EUROPEAN PATENT SPECIFICATION

(11) **EP 3 156 457 B1**
(45) Date of publication and mention of the grant of the patent: **05.09.2018**
(21) Application number: 16192994.8
(22) Date of filing: 10.10.2016
(51) Int. Cl.: C08L 83/04

(54) **INSULATING HEAT DISSIPATION SHEET**
WÄRMEABLEITENDE ISOLIEREFOLIE
FEUILLE DE DISSIPATION DE CHALEUR ISOLANTE

(30) Priority: 14.10.2015 JP 2015202624
(43) Date of publication of application: 19.04.2017
(73) Proprietor: Shin-Etsu Chemical Co., Ltd., Tokyo 100-0004 (JP)
(72) Inventor: SHIONO, Yoshiyuki, Japan, Gunma 379-0224 (JP)
(74) Representative: Zacco GmbH

(56) References cited:
- WO-A1-2014/196347

## Description

### [Technical field]

The present invention relates to an insulating heat dissipation sheet that is thermally conductive, and is used to transfer heat from a heat generating member(s) to a heat dissipation member(s) in, for example, an electric device, an electronic device, a light emitting device and an integrated circuit.

### [Background art]

In recent years, a high thermal conductivity and an insulation property have been required in a thermally conductive layer for transferring heat from a heat generating member(s) to a heat dissipation member(s) in, for example, an integrated circuit, an electric device, an electronic device and a light emitting device. In order to meet such requirements, there has been widely used a heat dissipation material with a filler being dispersed in a resin or a rubber. Here, as such filler, there is employed a hexagonal boron nitride (h-BN) having a high thermal conductivity and an insulation property.

The crystal structure of such hexagonal boron nitride is a layered structure similar to that of graphite, and the particle shape thereof is scale-like. The scale-like boron nitride has an anisotropic thermal conductivity where a high thermal conductivity is exhibited in a major axis direction (direction of axis a in hexagonal crystal), and a low thermal conductivity is exhibited in a minor axis direction (direction of axis c in hexagonal crystal). Such thermal conductivity in the major axis direction is said to be serval to tens of times higher than the thermal conductivity in the minor axis direction. As for a sheet obtained by combining a resin with a scale-like boron nitride (h-BN) having a large aspect ratio, arranged along a sheet direction is the major axis direction of the scale-like boron nitride (h-BN), thus resulting in an insufficient heat conductivity in a thickness direction of the sheet. For this reason, there has been anticipated a type of heat dissipation grease, paste, pad, sheet, film or a thermal conductive composition thereof where the scale-like boron nitride dispersed in a resin or a rubber stands vertically i.e. the major axis direction of the scale-like boron nitride is oriented identical to a heat transferring direction.

Further, in order to increase the thermal conductivity of a heat dissipation material, there has been proposed a method where used as a filling agent (filler) is a boron nitride aggregate obtained by agglutinating the primary particles of boron nitride.

Patent document 1 discloses a hexagonal boron nitride powder (i.e. boron nitride aggregate) where without using a binder, scale-like primary particles of a hexagonal boron nitride are aggregated to one another without orientation.

A high thermal conductivity is exhibited in an insulating heat dissipation sheet using such boron nitride aggregate as a filler. However, problems with such sheet are that cracks will easily occur at the time of forming a composition into a sheet; a part of the sheet will fall away in the midst of a forming step(s); and the sheet itself has a poor insulation property. In short, it is difficult to say that the boron nitride aggregate is able to exercise its full potential when used in such insulating heat dissipation sheet.

For example, working example 1 of Patent document 2 discloses a method of producing an insulating heat dissipation sheet by preparing a composition mainly composed of boron nitride and silicone, and then performing coating, drying and heat/press vulcanization on the same. However, problems with using a boron nitride aggregate having a large average particle diameter are that cracks will easily occur after drying; and a part of the sheet will fall away before performing heat/press vulcanization. Another problem is that a poor insulation property is often exhibited in a portion where cracks, if not the falling of the sheet have occurred.

Patent document 3 discloses a thermal conductive resin sheet using a boron nitride aggregate. Patent document 3 also discloses that this thermal conductive resin sheet has boron nitride aggregates with different cohesive strengths. Particularly, it is described that a boron nitride aggregate with a low cohesive strength will deform or collapse when cured under a pressure, thus making it possible to relax the stresses between boron nitride aggregates with large cohesive strengths, and restrict the occurrence of voids. However, there is a problem that heat conductivity will decrease as the boron nitride aggregates collapse when cured under pressure.

Patent document 4 discloses a heat-curable resin composition using a boron nitride aggregate; and a B-stage thermal conductive sheet. Further, Patent document 4 discloses that the boron nitride aggregate has a maximum cavity diameter of 5 to 80 µm for the purpose of maintaining an insulation property. However, there is a problem that there cannot be achieved a sufficient heat conductivity and insulation property even when using the B-stage thermal conductive sheet as it is. Another problem is that although heat/press vulcanization is effective in terms of achieving a sufficient heat conductivity and insulation property, the cavities in the boron nitride aggregate make it impossible to employ a sufficient pressure for performing heat/press vulcanization.

### [Prior art document]

### [Patent document]

Patent document 1: Japanese Patent No. 3461651
Patent document 2: JP-A-H11-60216
Patent document 3: Japanese Patent No. 5208060
Patent document 4: Japanese Patent No. 5340202
WO 2014/196347 discloses an adhesive heat dissipating sheet prepared by curing a composition comprising a polysiloxane having 2-100 repeat units and at least two alkenyl groups, a thermally conductive filler, an organohydrogenpolysiloxane with 2-100 repeat units, a platinum group metal catalyst, a silicone resin and an organic peroxide curing agent. The thermally conductive filler can be boron nitride powder.

### [Summary of the invention]

### [Problem to be solved by the invention]

It is an object of the present invention to provide a heat dissipation sheet using a boron nitride aggregate as a filler, and exhibiting none of the abovementioned problems. That is, the heat dissipation sheet of the invention has a heat conductivity and a heat resistance, exhibits no cracks and fallings in a forming step(s), and has a favorable insulation property.

### [Means to solve the problem]

The inventors of the invention diligently conducted a series of studies to solve the above problems, and completed the invention as follows. That is, the inventors found that the above problems could be solved by the following insulating heat dissipation sheet made of a cured product of an organopolysiloxane composition containing a boron nitride aggregate. Further, the heat dissipation sheet of the invention exhibits no cracks and fallings in a forming step(s) that are performed after the composition had been cured, but before the composition had been subjected to hot-press curing. The heat dissipation sheet of the invention has a favorable insulation property as a result of performing hot-press curing.

In short, the present invention is to provide the following insulating heat dissipation sheet and a production method thereof.
[1] An insulating heat dissipation sheet consisting of a cured product of an organopolysiloxane composition comprising:
   (a) 100 parts by mass of an organopolysiloxane exhibiting an average degree of polymerization of 3,000 to 10,000;
   (b) 10 to 100 parts by mass of an organopolysiloxane exhibiting an average degree of polymerization of 2 to 2,000, and having alkenyl groups only at both ends of a molecular chain thereof, but at no other position on the molecular chain;
   (c) 2 to 20 parts by mass of an organohydrogenpolysiloxane having hydrogen atoms directly bonded to silicon atoms (Si-H groups);
   (d) 100 to 300 parts by mass of a boron nitride aggregate;
   (e) 0.1 to 10 parts by mass of a peroxide cross-linking agent; and
   (f) 0.1 to 10 parts by mass of a platinum group curing catalyst.
[2] An insulating heat dissipation sheet consisting of the cured product of the organopolysiloxane composition as set forth in [1] and a fiber cloth.
[3] A production method of an insulating heat dissipation sheet, comprising:
   a step of obtaining a cured product of the organopolysiloxane composition as set forth in [1] by curing the composition at 50 to 100°C; and
   a step of hot forming such cured product by performing hot-press curing thereon at a temperature of not lower than 150°C.

### [Effect of the invention]

The heat dissipation sheet of the present invention has a heat conductivity and a heat resistance, exhibits no cracks and fallings in a forming step(s), and has a favorable insulation property. Therefore, the heat dissipation sheet of the present invention is advantageous in terms of productivity and cost, and is useful in transferring heat from a heat generating member(s) to a heat dissipation member(s) in, for example, an electric device, an electronic device, a light emitting device and an integrated circuit.

### [Mode for carrying out the invention]

The insulating heat dissipation sheet of the present invention is described in detail hereunder. However, the present invention is not limited to the following examples.

### (a) Organopolysiloxane exhibiting average degree of polymerization of 3,000 to 10,000

A resinous or rubber-like polymer may be used as a component (a). As such polymer, there may be preferably used a silicone, especially an organopolysiloxane represented by the following average composition formula (0).

RₐSiO_{(4-a)/2} (0)

In the above formula (0), R represents an identical or different substituted or unsubstituted monovalent hydrocarbon group, preferably a monovalent hydrocarbon group having 1 to 8 carbon atoms. Such monovalent hydrocarbon group may, for example, be substituted by a halogen atom(s) and/or a cyano group(s). Examples of the monovalent hydrocarbon group represented by R include an alkyl group such as a methyl group, an ethyl group and a propyl group; an alkenyl group such as a vinyl group and an allyl group; an aryl group such as a phenyl group and a tolyl group; and a cycloalkyl group such as a cyclohexyl group and a cyclopentyl group. The monovalent hydrocarbon group represented by R may also be a group obtained by substituting a part of or all the hydrogen atoms directly bonded to the carbon atoms in any of the abovementioned groups with, for example, halogen atoms and/or cyano groups. Examples of such substituted group include a chloromethyl group, a chloroethyl group, a trifluoropropyl group, a cyanoethyl group and a cyanopropyl group. Preferable examples of R are a methyl group, a phenyl group, a trifluoropropyl group and a vinyl group. a represents a positive number of 1.85 to 2.10. Although the organopolysiloxane as the component (a) exhibits an average degree of polymerization of 3,000 to 10,000, it is preferred that such average degree of polymerization be 5,000 to 10,000.

### (b) Organopolysiloxane exhibiting average degree of polymerization of 2 to 2,000 and having alkenyl groups only at both ends of its molecular chain

A component (b) used in the present invention is an organopolysiloxane having an alkenyl group bonded to a silicon atom, at each of the two terminal ends of its molecular chain (i.e. the component (b) has two of such alkenyl groups in total). Particularly, it is preferred that the main chain part of the component (b) be basically composed of repetitive diorganosiloxane units.

One specific example of the component (b) is that represented by the following general formula (1).

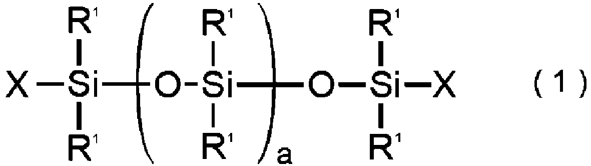

(In the above formula, each R¹ independently represents a substituted or unsubstituted monovalent hydrocarbon group having no aliphatic unsaturated bond; X represents an alkenyl group; and a represents a number of 0 to 2,000.)

In the above formula (1), examples of R¹ as a substituted or unsubstituted monovalent hydrocarbon group having no aliphatic unsaturated bond, include an alkyl group such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group and a dodecyl group; a cycloalkyl group such as a cyclopentyl group, a cyclohexyl group and a cycloheptyl group; an aryl group such as a phenyl group, a tolyl group, a xylyl group, a naphthyl group and a biphenylyl group; and an aralkyl group such as a benzyl group, a phenylethyl group, a phenylpropyl group and a methylbenzyl group. R¹ may also be a group obtained by substituting a part of or all the hydrogen atoms bonded to the carbon atoms in any of the abovementioned groups with, for example, halogen atoms such as fluorine atoms, chlorine atoms and bromine atoms; and/or cyano groups. Examples of such substituted group include those having 1 to 10 carbon atoms, particularly 1 to 6 carbon atoms, such as a chloromethyl group, a 2-bromoethyl group, a 3-chloropropyl group, a 3,3,3-trifluoropropyl group, a chlorophenyl group, a fluorophenyl group, a cyanoethyl group and a 3,3,4,4,5,5,6,6,6-nonafluorohexyl group. Among all of these examples of R¹, preferred are substituted or unsubstituted alkyl groups having 1 to 3 carbon atoms, such as a methyl group, an ethyl group, a propyl group, a chloromethyl group, a bromoethyl group, a 3,3,3-trifluoropropyl group and a cyanoethyl group; and substituted or unsubstituted phenyl groups such as a phenyl group, a chlorophenyl group and a fluorophenyl group. Here, all R¹s may be either identical to or different from one another.

Further, examples of X as an alkenyl group include alkenyl groups having about 2 to 8 carbon atoms, such as a vinyl group, an allyl group, a propenyl group, an isopropenyl group, a butenyl group, a hexenyl group and a cyclohexenyl group, among which lower alkenyl groups such as a vinyl group and an allyl group are preferred. Particularly, a vinyl group is preferred.

In the general formula (1), a represents a number of 0 to 2,000, and it is preferred that a be a number satisfying 10 ≤ a ≤ 2,000, more preferably 10 ≤ a ≤ 1,000. It is preferred that such organopolysiloxane (b) exhibiting an average degree of polymerization of 2 to 2,000 and having alkenyl groups only at the both ends of its molecular chain, be added in an amount of 10 to 100 parts by mass, particularly preferably 30 to 70 parts by mass, with respect to 100 parts by mass of the organopolysiloxane as the component (a).

### (c) Organohydrogenpolysiloxane

An organohydrogenpolysiloxane as a component (c) used in the present invention has hydrogen atoms directly bonded to silicon atoms on its molecular chain (i.e. Si-H groups).

One specific example of such organohydrogenpolysiloxane is that represented by the following average structural formula (2).

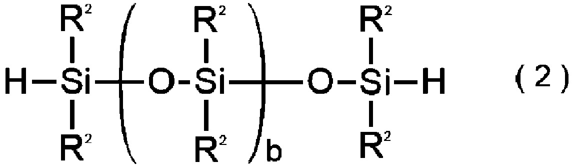

(In the above formula, each R² independently represents a substituted or unsubstituted monovalent hydrocarbon group having no aliphatic unsaturated bond; and b represents a number of 0 to 600.)

In the above formula (2), examples of R² as a substituted or unsubstituted monovalent hydrocarbon group having no aliphatic unsaturated bond, include an alkyl group such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group and a dodecyl group; a cycloalkyl group such as a cyclopentyl group, a cyclohexyl group and a cycloheptyl group; an aryl group such as a phenyl group, a tolyl group, a xylyl group, a naphthyl group and a biphenylyl group; and an aralkyl group such as a benzyl group, a phenylethyl group, a phenylpropyl group and a methylbenzyl group. R² may also be a group obtained by substituting a part of or all the hydrogen atoms bonded to the carbon atoms in any of the abovementioned groups with, for example, halogen atoms such as fluorine atoms, chlorine atoms and bromine atoms; and/or cyano groups. Examples of such substituted group include those having 1 to 10 carbon atoms, particularly 1 to 6 carbon atoms, such as a chloromethyl group, a 2-bromoethyl group, a 3-chloropropyl group, a 3,3,3-trifluoropropyl group, a chlorophenyl group, a fluorophenyl group, a cyanoethyl group and a 3,3,4,4,5,5,6,6,6-nonafluorohexyl group. Among all of these examples of R², preferred are substituted or unsubstituted alkyl groups having 1 to 3 carbon atoms, such as a methyl group, an ethyl group, a propyl group, a chloromethyl group, a bromoethyl group, a 3,3,3-trifluoropropyl group and a cyanoethyl group; and substituted or unsubstituted phenyl groups such as a phenyl group, a chlorophenyl group and a fluorophenyl group. Here, all R²s may be either identical to or different from one another.

Further, b in the formula (2) represents a number of 0 to 600, and it is preferred that b be a number of 0 to 500, more preferably 5 to 200. It is preferred that such organohydrogenpolysiloxane as the component (c) be added in an amount of 2 to 20 parts by mass, particularly preferably 4 to 10 parts by mass, with respect to 100 parts by mass of the organopolysiloxane as the component (a).

Further, examples of the organohydrogenpolysiloxane as the component (c) include those represented by the following average structural formulae (3) to (5). Each of these organohydrogenpolysiloxanes may be used singularly, or a number of them may be used together as a mixture.

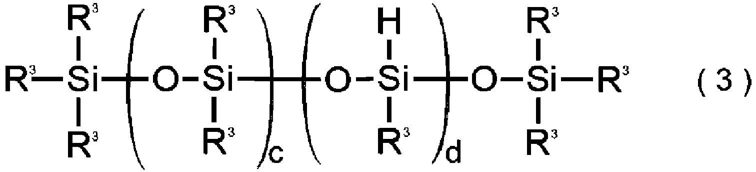

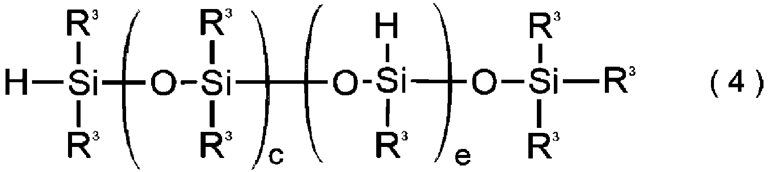

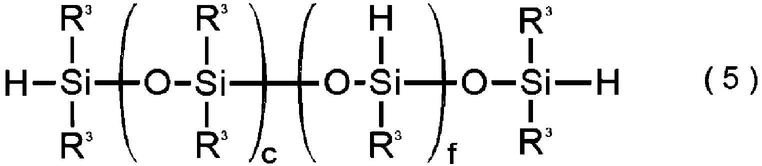

(In each of the above formulae, each R³ independently represents a substituted or unsubstituted monovalent hydrocarbon group having no aliphatic unsaturated bond; c represents a number of 0 to 600; and each of d, e and f represents a number not smaller than 1.)

In the above formulae (3) to (5), examples of R³ as a substituted or unsubstituted monovalent hydrocarbon group having no aliphatic unsaturated bond, include an alkyl group such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group and a dodecyl group; a cycloalkyl group such as a cyclopentyl group, a cyclohexyl group and a cycloheptyl group; an aryl group such as a phenyl group, a tolyl group, a xylyl group, a naphthyl group and a biphenylyl group; and an aralkyl group such as a benzyl group, a phenylethyl group, a phenylpropyl group and a methylbenzyl group. R³ may also be a group obtained by substituting a part of or all the hydrogen atoms bonded to the carbon atoms in any of the abovementioned groups with, for example, halogen atoms such as fluorine atoms, chlorine atoms and bromine atoms; and/or cyano groups. Examples of such substituted group include those having 1 to 10 carbon atoms, particularly 1 to 6 carbon atoms, such as a chloromethyl group, a 2-bromoethyl group, a 3-chloropropyl group, a 3,3,3-trifluoropropyl group, a chlorophenyl group, a fluorophenyl group, a cyanoethyl group and a 3,3,4,4,5,5,6,6,6-nonafluorohexyl group. Among all of these examples of R³, preferred are substituted or unsubstituted alkyl groups having 1 to 3 carbon atoms, such as a methyl group, an ethyl group, a propyl group, a chloromethyl group, a bromoethyl group, a 3,3,3-trifluoropropyl group and a cyanoethyl group; and substituted or unsubstituted phenyl groups such as a phenyl group, a chlorophenyl group and a fluorophenyl group. Here, all R3s may be either identical to or different from one another. Further, c in the formulae (3) to (5) represents a number of 0 to 600; and each of d, e and f represents a number not smaller than 1, particularly desirably a number of 2 to 10. It is preferred that such organohydrogenpolysiloxane as the component (c) be added in an amount of 2 to 20 parts by mass, particularly preferably 3 to 12 parts by mass, with respect to 100 parts by mass of the organopolysiloxane as the component (a).

### (d) Boron nitride aggregate

A boron nitride aggregate may be prepared by a known method, using the primary particles of a scale-like boron nitride. Specifically, the boron nitride aggregate is produced by agglutinating the primary particles of a scale-like boron nitride through a known method, and then sintering the same. Here, it is preferred that a sintering temperature be 1,950 to 2,050°C, particularly preferably 2,000°C. While there are no particular restrictions on an aggregation method, there may be employed a spray-drying method where sprayed from above is a slurry obtained by uniformly mixing the primary particles of a given scale-like boron nitride, a water-soluble binder and water, and where drying and granulation then take place as the droplets fall. The spray-drying method is often used in mass production, and can easily provide granules with a favorable mobility (secondary agglomerated particles). An average particle diameter of the boron nitride aggregate can be controlled by, for example, controlling a spraying rate in the granulation process, changing the kind of binder and chaining the kind of spray liquid.

It is preferred that the average particle diameter of the boron nitride aggregate be 16 to 100 µm. An average particle diameter of smaller than 16 µm will lead to a poor heat conductivity, and an average particle diameter of larger than 100 µm will lead to a poor insulation property. Here, the average particle diameter of the boron nitride aggregate is a cumulative average diameter on a volume basis, which is measured by a laser diffraction method.

It is preferred that such boron nitride aggregate as the component (d) be added in an amount of 100 to 300 parts by mass, particularly preferably 150 to 250 parts by mass, with respect to 100 parts by mass of the organopolysiloxane as the component (a).

### (e) Peroxide cross-linking agent

The present invention contains a cross-linking agent which is a peroxide, for the purpose of turning the organopolysiloxane into a rubber sheet through hot-press curing.

For example, an organic peroxide is used as the cross-linking agent. Specific examples of such organic peroxide include benzoyl peroxide, monochlorobenzoyl peroxide, bis 2,4-dichlorobenzoyl peroxide, o-methylbenzoyl peroxide, p-methylbenzoyl peroxide, di (t-butyl) perbenzoate, dicumyl peroxide, 2,5-dimethyl-2,5-bis (t-butylperoxy) hexane and di (t-butyl) peroxide. It is preferred that such peroxide cross-linking agent be added in an amount of 0.1 to 10 parts by mass, particularly preferably 0.2 to 5 parts by mass, with respect to 100 parts by mass of the organopolysiloxane as the component (a).

### (f) Platinum group curing catalyst

A platinum group curing catalyst (f) used in the present invention is a catalyst for promoting an addition reaction between the alkenyl groups in the component (b) and the Si-H groups in the component (c). As such platinum group curing catalyst (f), there may be used a known catalyst for hydrosilylation reaction. Specific examples of such catalyst (f) include platinum-group metal elements such as platinum (including platinum black), rhodium and palladium; platinum chlorides, chloroplatinic acids and chloroplatinic acid salts, such as H₂PtCl₄·nH₂O, H₂PtCl₆·nH₂O, NaHPtCl₆·nH₂O, KHPtCl₆·nH₆O, Na₂PtCl₆·nH₂O, K₂PtCl₄·nH₂O, PtCl₄·nH₂O, PtCl₂ and Na₂HPtCl₄·nH₂O (provided that n in these formulae is an integer of 0 to 6, preferably 0 or 6); alcohol-modified chloroplatinic acids; a complex of a chloroplatinic acid and olefin; a compound with a platinum-group metal such as platinum black or palladium being supported on a support such as alumina, silica or carbon; a rhodium-olefin complex; a chlorotris (triphenylphosphine) rhodium(Wilkinson's catalyst); and a complex of any of a platinum chloride, chloroplatinic acid or chloroplatinic acid salt and a vinyl group-containing siloxane, especially a vinyl group-containing cyclic siloxane. It is preferred such platinum group curing catalyst be added in an amount of 0.1 to 10 parts by mass, particularly preferably 0.2 to 5 parts by mass, with respect to 100 parts by mass of the organopolysiloxane (a).

### Other components

Components other than those described above may also be added to the present invention if necessary. Such components are added in an amount of not larger than 35% by mass, preferably not larger than 30% by mass, with respect to the whole composition of the invention. Examples of such components include a filling reinforcement agent, a dispersing agent, a flame-retardant auxiliary agent, a heat-resistant auxiliary agent, an organic solvent for dilution, a pigment for coloring, and reaction inhibitors such as ethynylmethyldecylcarbinol and ethynylcyclohexanol.

Further, at the time of forming the insulating heat dissipation sheet, there may be contained, if needed, a glass fiber cloth serving as a core part, or a glass fiber cloth impregnated with a composition containing a thermal conductive filler. Such thermal conductive filler may be a substance normally considered as a thermal conductive filler. Specific examples of such thermal conductive filler include metal oxides such as alumina, silica, magnesia, red iron oxide, beryllia, titania and zirconia; metal nitrides such as aluminum nitride, silicon nitride and boron nitride; and artificial diamonds or silicon carbides. Any one of these thermal conductive fillers may be used singularly, or two or more of them may be mixed and used in combination. Moreover, there may also be employed two or more kinds of particles with different average particle diameters.

### Production method of insulating heat dissipation sheet

There are no particular restrictions on a method for producing the insulating heat dissipation sheet of the invention. However, it is preferred that such method include a step of obtaining a cured product of the organopolysiloxane composition having the above components, by curing such organopolysiloxane composition at 50 to 100°C; and a step of hot forming such cured product of the organopolysiloxane composition, by performing hot-press curing thereon at a temperature of not lower than 150°C.

When the temperature is lower than 50°C in the step of performing curing reaction at 50 to 100°C, weak addition cross-linking reactions will not progress such that cracks and falling may occur in forming steps that are performed after the composition had been cured, but before the composition had been subjected to hot-press curing. Further, when the temperature is higher than 100°C, cross-linking reactions by the peroxide(s) will slightly progress such that the composition may not be sufficiently pressed when performing hot-press curing, and that there may thus not be achieved a favorable heat conductivity and a favorable insulation property.

In the step for performing pressure forming through hot-press curing at a temperature of not lower than 150°C, a temperature lower than 150°C will cause the cross-linking reactions by the peroxide(s) to progress insufficiently such that there may not be obtained an insulating heat dissipation sheet with an sufficient strength.

### Working example

The present invention is described in greater detail hereunder with reference to working and comparative examples. However, the present invention is not limited to the following examples.

### Working example 1

### (1) Preparation of boron nitride aggregate

### • Calcination of boron nitride

A scale-like boron nitride having a purity of 93% and exhibiting a relatively low crystallinity, was calcined at 1,800°C for an hour under a nitrogen atmosphere, followed by performing a pulverization treatment on the same for 3 hours using a grinding mixer.

### • Granulation treatment of boron nitride

An amount of 500 g of the scale-like boron nitride that had been calcined and subjected to the pulverization treatment, was placed in a fluidized bed granulating-drying-coating machine (MP-01 by Powrex Corporation). Water of 250 g was also put into the fluidized bed granulating-drying-coating machine so as to perform a granulation treatment of boron nitride at a charge air temperature of 80°C and a spraying rate of 4 g/min.

### • Sintering of boron nitride

The granulated boron nitride was sintered at 2,000°C for two hours under a nitrogen atmosphere.

### • Acid treatment

The sintered boron nitride was washed by a nitric acid aqueous solution, and then dried at 130°C for two hours.

### • Average particle diameter

An average particle diameter was obtained as a volume-based cumulative average diameter through a laser diffraction method. The average particle diameter was 53 µm.

### (2) Preparation of composition

An amount of 100 parts by mass of a polydimethylsiloxane as the component (a) exhibiting an average degree of polymerization of about 6,000 (KE-78VBSR by Shin-Etsu Chemical Co., Ltd.) and an amount of 340 parts by mass of xylene were put into a mixer so as to be stirred and mixed together. Further, 200 parts by mass of the above boron nitride aggregate as the component (d) were put thereinto so as to be stirred and mixed with the other components. Furthermore, 50 parts by mass of an organopolysiloxane as the component (b) having alkenyl groups only at both ends of its molecular chain, but at no other position thereon (VF-600 by Shin-Etsu Chemical Co., Ltd.) were put thereinto so as to be stirred and mixed with the other components. Next, 3 parts by mass of a peroxide cross-linking agent (PERHEXA 25B by NOF Corporation) as the component (e) and 1 part by mass of a platinum group curing catalyst (CAT-PL-5 by Shin-Etsu Chemical Co., Ltd.) as the component (f) were put thereinto so as to be stirred and mixed with the other components. An ethynylmethyldecylcarbinol (EMDC by HOKKO CHEMICAL INDUSTRY CO., LTD.) of 0.4 parts by mass was further put thereinto so as to be stirred and mixed with the other components. Finally, 7 parts by mass of an organohydrogenpolysiloxane as the component (c) having hydrogen atoms directly bonded to silicon atoms (Si-H groups) (104HDM by Shin-Etsu Chemical Co., Ltd.) and 70 parts by mass of xylene were put thereinto so as to be stirred and mixed with the other components, thus obtaining the composition of the invention.

### (3) Production of dried and cured product

The composition thus prepared was coated on a PET film using a doctor blade, followed by using a drier to heat, dry and cure the same at 80°C for 10 min.

Crack evaluation was performed as follows. That is, the dried and cured product thus obtained was cut by a cutter into 25 mm × 300 mm specimens. Counted was the number of specimens showing intense falling of the dried and cured product from a cut surface. As a result of preparing five specimens, it was confirmed that none of them had exhibited intense falling of the dried and cured product.

### (4) Forming by hot-press curing

The dried and cured product obtained was cut by a cutter into two 200 mm × 300 mm specimens. The two specimens were then stacked on top of each other in a way such that the surfaces of the dried and cured product would come into contact with each other, followed by performing hot-press curing thereon under a pressure of 150 kg/cm² and at a temperature of 170°C for 10 min. The PET film was peeled away after performing hot-press curing, thereby obtaining an insulating heat dissipation sheet of a thickness of 0.45 mm.

A thermal resistance test was performed as a way of evaluating a heat transfer property. A TIM Tester (by Analysis Tech, Inc.) was used to measure a thermal resistance value at a temperature of 50°C and under a pressure of 500 kPa. The measure thermal resistance value was 1.22 cm²·K/W.

A voltage resistance test was performed as a way of evaluating an insulation property. Specifically, a DC voltage of 4 kV was applied to both sides of each insulating heat dissipation sheet for 10 sec, followed by counting the number of short-circuited sheets. After performing the voltage resistance test on 50 specimens thereof, it was confirmed that none of them had been short-circuited.

These results are shown in Table 1.

### Working example 2 to 6; comparative examples 1 and 2

Compositions were obtained, and evaluations thereof were later performed in the similar manner as the working example 1, except that the components and composition amounts shown in Table 1 were employed. The results are shown in Table 1.

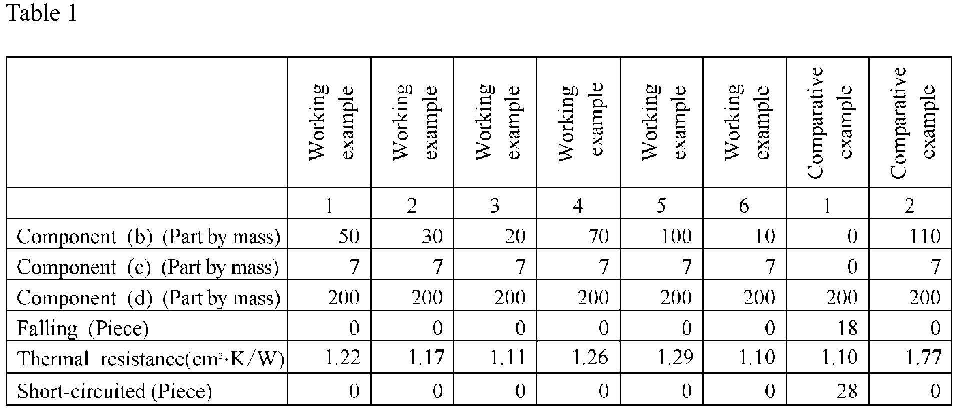

### Working example 7

A composition was obtained, and evaluations thereof were later performed in the similar manner as the working example 1, except that there was employed 4 parts by mass of the organohydrogenpolysiloxane as the component (c) having hydrogen atoms directly bonded to silicon atoms (Si-H groups) (104HDM by Shin-Etsu Chemical Co., Ltd.).

### Working example 8

A composition was obtained, and evaluations thereof were later performed in the similar manner as the working example 1, except that there was employed 10 parts by mass of the organohydrogenpolysiloxane as the component (c) having hydrogen atoms directly bonded to silicon atoms (Si-H groups) (104HDM by Shin-Etsu Chemical Co., Ltd.).

### Working example 9

A composition was obtained, and evaluations thereof were later performed in the similar manner as the working example 1, except that the dried and cured product obtained was cut by a cutter into two 200 mm × 300 mm specimens, the two specimens were then stacked on top of each other with a glass cloth being sandwiched therebetween in a way such that the surfaces of the dried and cured product would face each other, and hot-press curing was then performed thereon under the pressure of 150 kg/cm² and at the temperature of 170°C for 10 min.

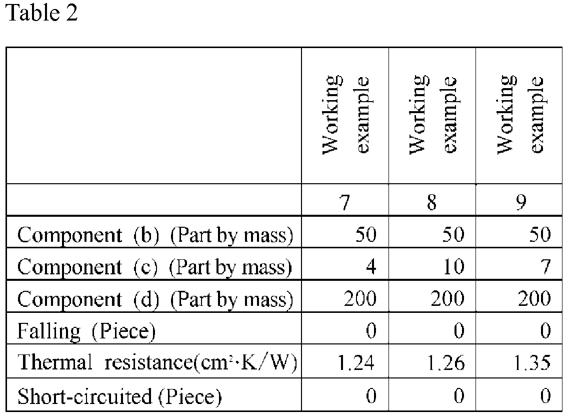

As shown in the above results, it is clear that the insulating heat dissipation sheet of the present invention hardly produces cracks; and has a favorable insulation property.

## Claims

1. An insulating heat dissipation sheet consisting of a cured product of an organopolysiloxane composition comprising:
(a) 100 parts by mass of an organopolysiloxane exhibiting an average degree of polymerization of 3,000 to 10,000;
(b) 10 to 100 parts by mass of an organopolysiloxane exhibiting an average degree of polymerization of 2 to 2,000, and having alkenyl groups only at both ends of a molecular chain thereof, but at no other position on the molecular chain;
(c) 2 to 20 parts by mass of an organohydrogenpolysiloxane having hydrogen atoms directly bonded to silicon atoms (Si-H groups);
(d) 100 to 300 parts by mass of a boron nitride aggregate;
(e) 0.1 to 10 parts by mass of a peroxide cross-linking agent; and
(f) 0.1 to 10 parts by mass of a platinum group curing catalyst.

2. An insulating heat dissipation sheet consisting of the cured product of the organopolysiloxane composition as set forth in claim 1 and a fiber cloth.

3. A production method of an insulating heat dissipation sheet, comprising:
a step of obtaining a cured product of said organopolysiloxane composition as set forth in claim 1 by curing said composition at 50 to 100°C; and
a step of hot forming said cured product by performing hot-press curing thereon at a temperature of not lower than 150°C.

## Patentansprüche

1. Wärmeableitende Isolierfolie bestehend aus einem ausgehärteten Produkt einer Organopolysiloxanzusammensetzung umfassend:
(a) 100 Massenteile eines Organopolysiloxans, das einen durchschnittlichen Polymerisationsgrad von 3.000 bis 10.000 aufweist;
(b) 10 bis 100 Massenteile eines Organopolysiloxans, das einen durchschnittlichen Polymerisationsgrad von 2 bis 2.000 aufweist und nur an beiden Enden einer Molekülkette davon, jedoch an keiner anderen Position in der Molekülkette, über Alkenylgruppen verfügt;
(c) 2 bis 20 Massenteile eines Organowasserstoff-Polysiloxans mit direkt an Siliziumatome (Si-H-Gruppen) gebundenen Wasserstoffatomen;
(d) 100 bis 300 Massenteile eines Bornitrid-Aggregats;
(e) 0,1 bis 10 Massenteile eines Peroxid-Vernetzungsmittels; und
(f) 0,1 bis 10 Massenteile eines Aushärtungskatalysators für eine Platingruppe.

2. Wärmeableitende Isolierfolie bestehend aus dem ausgehärteten Produkt der Organopolysiloxanzusammensetzung nach Anspruch 1 und einem Fasertuch.

3. Verfahren zur Herstellung einer wärmeableitenden Isolierfolie, umfassend:
einen Schritt des Erhaltens eines ausgehärteten Produkts der Organopolysiloxanzusammensetzung nach Anspruch 1 durch Aushärten der Zusammensetzung bei 50 bis 100 °C; und
einen Schritt des Warmformens des ausgehärteten Produkts durch Durchführen des Warmpresshärtens darauf bei einer Temperatur von nicht weniger als 150 °C.

## Revendications

1. Feuille de dissipation thermique isolante consistant en un produit durci d'une composition d'organopolysiloxane, comprenant :
(a) 100 parties en masse d'un organopolysiloxane présentant un degré moyen de polymérisation de 3.000 à 10.000 ;
(b) 10 à 100 parties en masse d'un organopolysiloxane présentant un degré moyen de polymérisation de 2 à 2.000, et ayant des groupes alcényle seulement aux deux extrémités d'une chaîne moléculaire de celle-ci, mais à aucune autre position sur la chaîne moléculaire ;
(c) 2 à 20 parties en masse d'un organohydrogénopolysiloxane ayant des atomes d'hydrogène directement liés à des atomes de silicium (groupes Si-H) ;
(d) 100 à 300 parties en masse d'un agrégat de nitrure de bore ;
(e) 0,1 à 10 parties en masse d'un agent de réticulation de type peroxyde ; et
(f) 0,1 à 10 parties en masse d'un catalyseur de durcissement de groupe du platine.

2. Feuille de dissipation thermique isolante consistant en un produit durci d'une composition d'organopolysiloxane selon la revendication 1 et une étoffe fibreuse.

3. Procédé de production d'une feuille de dissipation thermique isolante, comprenant :
une étape d'obtention d'un produit durci de ladite composition d'organopolysiloxane selon la revendication 1 en durcissant ladite composition à une température de 50 to 100°C ; et
une étape de formation à chaud dudit produit durci en y effectuant un durcissement à la presse à chaud à une température non inférieure à 150°C.
